# EUROPEAN PATENT APPLICATION

(11) **EP 2 242 098 A1**
(43) Date of publication of application: **20.10.2010**
(21) Application number: 09158081.1
(22) Date of filing: 16.04.2009
(51) Int. Cl.: H01L 23/13

(54) **Single side rail substrate**

(71) Applicant: NXP B.V., 5656 AG Eindhoven (NL)
(72) Inventor: Lin, Barry, 5656, AE Eindhoven (NL)
(74) Representative: Schouten, Marcus Maria

(57) **Abstract**

It is described a substrate strip assembly (100) extending along a longitudinal direction, the substrate strip assembly (100) comprising a substrate strip (101), having a plurality of package regions (104) each of which package regions (104) includes an integrated circuit, and a single side rail (108) extending on a single side of said substrate strip (101) in said longitudinal direction, said side rail (108) comprising at least one feature for processing said substrate strip assembly (100). According to an embodiment, the substrate strip assembly (100) is formed by singularizing a substrate panel. A cassette comprises an asymmetric slot configuration is provided for handling the substrate strip/substrate strip assembly (100).

## Description

### Field of invention

The present invention relates to the field of integrated circuit manufacturing.

### Art Background

In integrated circuit manufacturing, individual devices (packages) are formed from substrate strip assemblies which include a plurality of devices which are separated in a singularizing step. The substrate strips include side rails on opposing sides of the substrate strip assemblies which side rails assist in processing of the substrate strips.

In view of the above-described situation, there exists a need for an improved technique that enables to provide substrate strip assemblies having improved characteristics.

### Summary of the Invention

This need may be met by the subject matter according to the independent claims. Advantageous embodiments of the herein disclosed subject matter are described by the dependent claims.

According to a first aspect of the herein disclosed subject matter there is provided a substrate strip assembly, the substrate strip assembly comprising (i) a substrate strip having a plurality of package regions each of which package regions includes an integrated circuit, and (ii) a single side rail extending on a single side of said substrate strip, said side rail comprising at least one feature for processing said substrate strip assembly.

This aspect of the invention is based on the idea that a single side rail may be sufficient for processing the substrate strip assembly if the processing chain is adapted accordingly. The package regions of the substrate strip assembly are separable into individual packages wherein each package comprises an integrated circuit.

According to an embodiment, a side rail is a portion of the substrate strip which is outside a functional area of the substrate strip. According to an embodiment, the functional area includes a ball grid area where a ball grid array is located, a bonding area where a package housing is bonded to the substrate strip, etc. According to an embodiment, the term "side rail" includes both, top and bottom surface of the side rail. For example, a statement of the form "a side rail is a portion of the substrate strip which is outside a functional area" herein includes "top and bottom surfaces of the side rail being outside a functional area of the substrate strip".

According to a further embodiment, a side rail is a portion of the substrate strip which is removed in the final product, e.g. by sawing, cleaving, etc. For example, in one embodiment, the side rail portion of the substrate strip is configured for removal.

Features for processing the substrate strip assembly include, e.g., manufacturing holes, fiducial marks, a part number, a substrate space for gripping the substrate strip assembly, a substrate space for being inserted in a holder e.g. in the form of a cassette, etc.

According to an embodiment of the first aspect, the plurality of package regions are located side by side along an longitudinal direction. According to a further embodiment, the substrate strip assembly extends along the longitudinal direction. According to a further embodiment, the single side rail extends along the longitudinal direction.

According to a further embodiment of the first aspect, the substrate strip is formed of a rigid material. According to a further embodiment, the substrate strip is formed by separating a substrate panel into individual substrate strips wherein each substrate strip itself comprises a plurality of package regions.

According to a further embodiment of the first aspect, the substrate strip assembly further comprises a package housing in at least one of the package regions wherein the package housing has a package edge. Further, the substrate strip has an opposite edge on an opposite side, opposite the side rail. According to an embodiment, the opposite edge is opposite a side rail edge of the single side rail.

According to an embodiment, the package edge and said opposite edge are flush with respect to each other. In this way, the substrate area can be used very efficiently, since there is no unused (unoccupied) substrate area on the opposite side of the substrate strip assembly.

According to a further embodiment, the package edge and the opposite edge are spaced apart with respect to each other. The distance between the package edge and the opposite edge of the substrate may facilitate handling of the substrate strip assembly without damaging the package housing while still allowing a efficient usage of the substrate area.

According to further embodiment of the first aspect, the substrate strip assembly further comprises a ball grid array in at least one of said package regions. At least part of the balls of the ball grid array define an outer edge of the ball grid array on the opposite side.

According to an embodiment, the outer edge of the ball grid array and the opposite edge are flush with respect to each other. This allows for an efficient usage of the substrate area for the ball grid array.

According to a further embodiment, the outer edge of the ball grid array and the opposite edge are spaced apart with respect to each other. The distance between the ball grid array and the opposite edge of the substrate strip may facilitate handling of the substrate strip assembly without damaging the ball grid array, while still allowing for an efficient usage of the substrate area.

According to a further embodiment, at least one of the ball grid array and the package housing are spaced on apart from the opposite edge of the substrate. According to an embodiment, the distance between the ball grid array and the opposite edge of the substrate strip is three times the ball diameter of the balls of the ball grid array or less. According to a further embodiment, the distance between the ball grid array and the opposite edge of the substrate strip is two times the ball diameter of the balls of the ball grid array or less. According to an embodiment, the ball diameter is defined as the largest diameter of an area the ball occupies on the substrate strip. According to a further embodiment, the distance between the ball grid array and the opposite edge of the substrate strip is equal to the ball diameter of the balls of the ball grid array or less. According to a further embodiment, the distance between the package housing and the opposite edge of the substrate strip is in one of the aformentioned ranges for the distance between the ball grid array and the opposite edge of the substrate strip.

According to a second aspect of the herein disclosed subject matter, a substrate panel is provided, the substrate panel comprising at least two substrate strip regions which are separable into individual substrate strips, wherein each of said substrate strips has a plurality of package regions. Further, a single side rail extends on a single side of each of the substrate strips. The number and the arrangement of substrate strip regions depends on the particular application.

According to an embodiment, said side rail comprises at least one feature for processing said substrate strip assembly, as described above. According to a further embodiment, the substrate panel is separated into the individual substrate strips before mounting any component to the substrate strip. According to other embodiments, one or more component (e.g. an integrated circuit) of each package region (104) is mounted to the substrate strip region before separating the substrate panel into individual substrate strips. For example, before separating the substrate panel, the substrate strip regions of the substrate panel may be configured in accordance with a substrate strip described with regard to the first aspect or an embodiment thereof.

According to a third aspect of the herein disclosed subject matter, a cassette for receiving a substrate strip assembly according to the first aspect or an embodiment thereof is provided. The cassette according to the first aspect comprises a first slot for receiving said side rail edge of said substrate strip and a second slot comprising a first recess for receiving an opposite edge of said substrate strip, wherein the opposite edge is opposite said side rail edge. The second slot comprises a second recess for receiving a package housing or balls of a ball grid array of said opposite edge of said substrate strip.

According to an embodiment, two or more pairs of slots are provided by the cassette, wherein each pair of slots comprises a first slot and a second slot; hence, the cassette is thereby capable of receiving two or more substrate strip assemblies according to the first aspect or an embodiment thereof.

According to a fourth aspect of the herein disclosed subject matter a method of fabricating packages comprising an integrated circuit is provided, the method comprising (i) providing a substrate strip comprising a plurality of package regions which are separable into said packages, wherein said substrate strip comprises a single side rail extending on a single side of said substrate strip, e.g. in said longitudinal direction of the substrate strip. According to an embodiment, the side rail comprises at least one feature for processing said substrate strip using said at least one feature. The method according to the fourth aspect further comprises removing said side rail from said substrate strip.

According to a further embodiment of the fourth aspect, the method providing said substrate strip comprises (i) providing a substrate panel comprising at least two substrate strip regions and (ii) separating said at least two substrate strip regions, thereby providing said substrate strip.

According to a further embodiment of the fourth aspect, the method comprises singularizing the package regions of each substrate strip into individual packages.

In the following there will be described exemplary aspects and embodiments of the subject matter disclosed herein e.g. with reference to a substrate strip assembly and a method for fabricating packages comprising an integrated circuit. It has to be pointed out that of course any combination of features relating to different aspects of the herein disclosed subject matter is also possible. In particular, some embodiments have been described with reference to apparatus type claims whereas other embodiments have been described with reference to method type claims. However, a person skilled in the art will gather from the above and the following description that, unless other notified, in addition to any combination of features belonging to one aspect also any combination between features relating to different aspects or embodiments, for example even between features of the apparatus type claims and features of the method type claims is considered to be disclosed with this application.

The aspects and embodiments defined above and further aspects and embodiments of the present invention are apparent from the examples of embodiment to be described hereinafter which are explained with reference to the drawings, but to which the invention is not limited.

### Brief Description of the Drawings

Fig. 1 shows a top view of a substrate strip assembly according to embodiments of the herein disclosed subject matter.
Fig. 2 shows a top view further substrate strip assembly according to embodiments of the herein disclosed subject matter.
Fig. 3 shows a bottom view of a substrate strip assembly according to embodiments of the herein disclosed subject matter.
Fig. 4 shows a substrate panel according to embodiments of the herein disclosed subject matter.
Fig. 5 shows a cassette for receiving a substrate strip assembly according to embodiments of the herein disclosed subject matter.

### Detailed Description

The illustration in the drawings is schematic. It is noted that in different figures, similar or identical elements are provided with the same reference signs or with reference signs, which are different from the corresponding reference signs only within the first digit or an appended character.

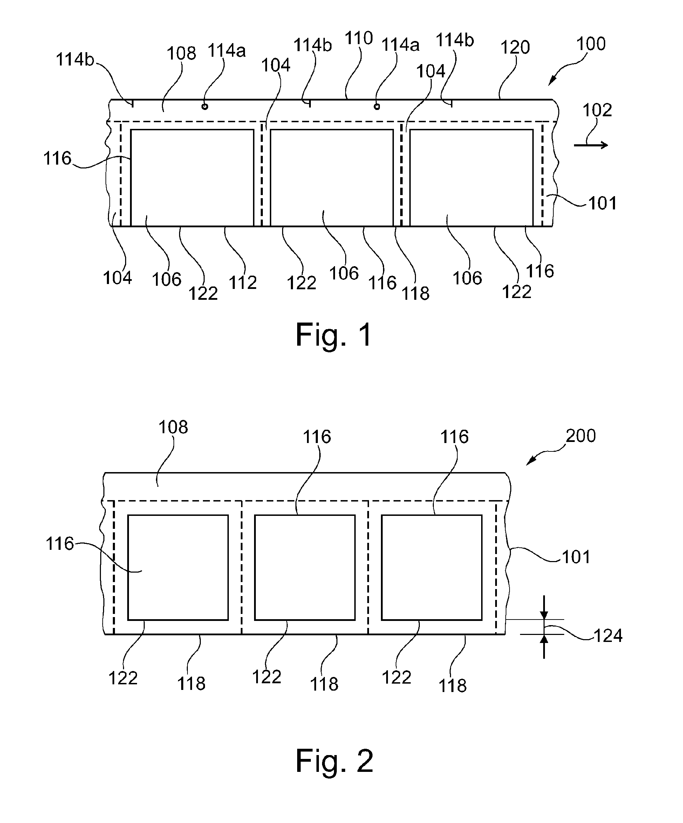

Figure 1 shows a top view of a substrate strip assembly 100 according to embodiments of the herein disclosed subject matter. The substrate strip assembly 100 includes a substrate strip 101 which extends along a longitudinal direction 102. The substrate strip assembly 100 comprises a plurality of package regions 104 each of which includes an integrated circuit 106 mounted on the substrate strip 101. According to an embodiment, the plurality of package regions 104 is located side by side along said longitudinal direction 102.

According to a further embodiment, the package region 104 defines the area of the substrate which is maintained in the final product or which is obtained by singularizing the package regions 104. According to an embodiment, singularizing of the package regions 104 is performed by known methods, e.g. sawing, cleaving, etc.

A single side rail 108 extends on a single side 110 of said substrate strip 101 in said longitudinal direction 102. In other words, the side 112 which is opposite the aforementioned single side 110 is free of a side rail. As is known to those skilled in the art, the side rail 110 comprises at least one feature for processing said substrate strip, e.g. manufacturing holes 114a, fiducial marks 114b, a part number (not shown in Fig. 1), etc. According to an embodiment, the side rail 108 is intended to be removed from the package region 104 in the final product.

According to an embodiment, the substrate strip 101 is formed of a rigid material. The substrate strip 101 has a substrate edge 118 (referred to as opposite edge in the following) on the opposite side 112 opposite the side 110 on which the side rail 108 is located. In this sense, the substrate strip 101 comprises a side rail edge 120.

According to an embodiment, the substrate strip assembly 100 comprises a package housing 116 in at least one of said package regions 104. According to an embodiment, the integrated circuit 106 is contained in the package housing 116. The package housing 116 has a package edge 122 which is flush with respect to the substrate edge 118 on the opposite side 112, as shown in Fig. 1.
Fig. 2 shows another substrate strip assembly 200 according to illustrative embodiments of the herein disclosed subject matter. According an embodiment, shown in Fig. 2, the package edge 122 and said substrate edge 118 are spaced apart with respect to each other by a distance 124. For example, the distance 124 may be equal to the diameter of a ball of a ball grid array (or, according to other embodiments, less than that). Besides these differences, the substrate strip assembly 200 corresponds to the substrate strip assembly 100 shown in Fig 1 and the details thereof are not repeated here.

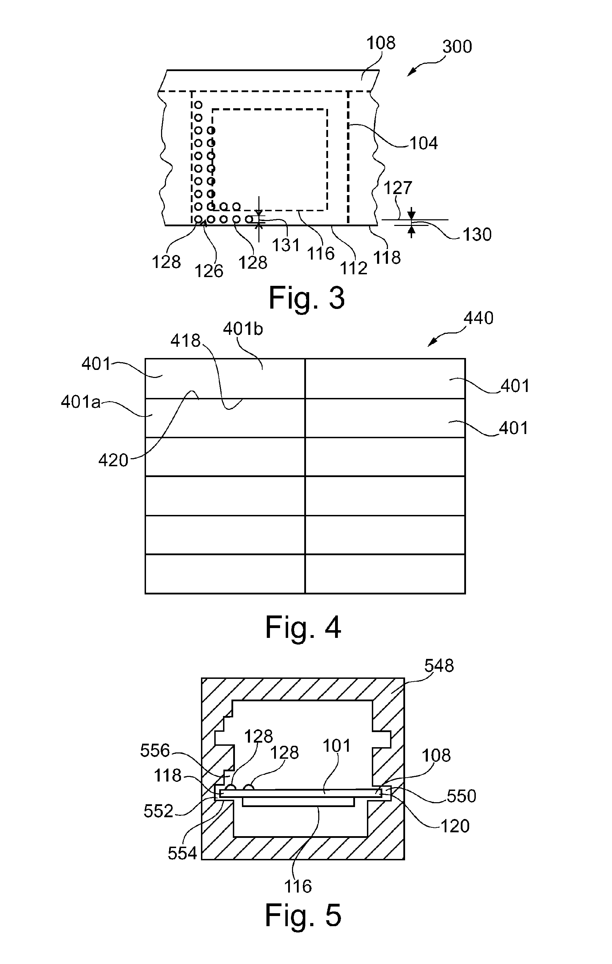

Fig. 3 shows a bottom view of a package region 104 according to illustrative embodiments of the herein disclosed subject matter. Accordingly, the package housing 116 is shown in phantom in Fig. 3. It should be noted that the top view of the package region 104 in Fig. 3 may be similar or identical to the top views of the package regions 104 of the substrate strips shown in Fig. 1 and Fig. 2.

According to an embodiment, the substrate strip assembly 100 comprises a ball grid array 126 in at least one of said package regions 104, of which the some balls 128 are shown in Fig. 3. According to an embodiment, the ball grid array 126 is located on a bottom of the substrate strip assembly 300, as shown in Fig. 3. In this embodiment, the ball grid array 126 is located over a surface of the substrate strip 101 which is opposite the surface over which the package housing 116 is located.

According to an embodiment, part of the balls of said ball grid array 126 define an outer edge of said ball grid array on said opposite side 112. The outer edge of the ball grid array which defines the distance between the ball grid array 126 and the opposite edge 118 is indicated at 127 in Fig. 3. According to an embodiment, the outer edge of the ball grid array 126 and the substrate edge 118 are spaced apart from each other by a distance 130, as shown in Fig. 3. According to an embodiment, the distance 130 is less or equal a diameter 131 of the balls 128 which define the outer edge of the ball grid array 126.

According to other embodiments (not shown in the figures) the outer edge of said ball grid array 126 and said substrate edge 118 are flush with respect to each other.
Fig. 4 shows a substrate panel 440 according to embodiments of the herein disclosed subject matter. According to an embodiment, the substrate panel 440 comprises at least two substrate strip regions 401 which are separable into individual substrate strips or substrate strip assemblies as described before. For example, a side rail edge region 420 forming a side rail edge of a substrate strip 401a may be located directly adjacent an opposite edge region 418 forming an opposite edge 118 of another substrate strip 401b. However, other configurations are possible.
Fig. 5 shows a cross-sectional view of a cassette 548 for receiving a substrate strip according to embodiments of the herein disclosed subject matter. According to an embodiment, the cassette 548 comprises a first slot 550 for receiving said side rail edge 120 of the side rail 108 of said substrate strip 101. Further in this embodiment, the cassette 548 comprises a second slot 552 for receiving the opposite edge 118 of the substrate strip 101. The second slot 552 comprises a first recess 554 for receiving an opposite edge 118 of said substrate strip, said opposite edge being opposite said side rail edge 120. Further, the second slot 552 comprises a second recess 556 for receiving balls 128 of a ball grid array of said opposite side 112, i.e. the balls 128 which are close to the opposite edge 118.

More generally speaking, according to an embodiment, the cassette 548 has first slots 550 and second slots 552 facing the first slots 550, wherein the first slots 550 and the second slots 552 have a different shape. For example, according to an embodiment, the first slot consists of a single recess and the second slot comprises two or more recesses, thereby allowing receiving components of a substrate strip assembly which are located outside a side rail of the substrate strip assembly.

It should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

In order to recapitulate the above described embodiments of the present invention one can state:
It is described a substrate strip assembly extending along a longitudinal direction, the substrate strip assembly comprising a substrate strip, having a plurality of package regions each of which package regions includes an integrated circuit, and a single side rail extending on a single side of said substrate strip in said longitudinal direction, said side rail comprising at least one feature for processing said substrate strip assembly. According to an embodiment, the substrate strip assembly is formed by singularizing a substrate panel. A cassette comprises an asymmetric slot configuration is provided for handling the substrate strip/substrate strip assembly.

List of reference signs:
- 100, 200, 300: substrate strip assembly
- 101: substrate strip
- 102: longitudinal direction
- 104: package regions
- 106: integrated circuit
- 108: side rail
- 110: side on which side rail 108 is located
- 112: opposite side
- 114a: manufacturing holes
- 114b: fiducial marks
- 116: package housing
- 118: substrate (opposite) edge
- 120: side rail edge
- 122: package edge
- 124: distance between substrate edge and package edge
- 126: ball grid array
- 127: outer edge of ball grid array
- 128: balls of 126
- 130: distance between ball grid array and substrate edge
- 131: diameter of balls 128
- 440 401, 401a, 401b: substrate panel substrate strip regions
- 420: side rail edge region
- 418: opposite edge region
- 548: cassette
- 550: first slot
- 552: second slot
- 554: first recess of the second slot
- 556: second recess of the second slot

## Claims

1. A substrate strip assembly (100, 200, 300) extending along a longitudinal direction (102), the substrate strip assembly (100, 200, 300) comprising:
- a substrate strip (101) having a plurality of package regions (104) each of which package regions (104) includes an integrated circuit;
- a single side rail (108) extending on a single side of said substrate strip (101) in said longitudinal direction (102), said side rail (108) comprising at least one feature for processing said substrate strip assembly (100, 200, 300).

2. The substrate strip assembly (100, 200, 300) of claim 1,
- said plurality of package regions (104) being located side by side along said longitudinal direction.

3. The substrate strip assembly (100, 200, 300) of claim 1 or 2,
- said substrate strip (101) being formed of a rigid material.

4. The substrate strip assembly (100, 200, 300) of one of claims 1 to 3, further comprising:
- a package housing (116) in at least one of said package regions (104), said package housing having a package edge (122);
- said substrate strip (101) having a opposite edge (118) on an opposite side opposite a side rail edge (120) of said single side rail (108); and
- said package edge (122) and said opposite edge (118) being flush with respect to each other.

5. The substrate strip assembly (100, 200, 300) of one of claims 1 to 3, further comprising:
- a package housing (116) in at least one of said package regions (104), said package housing having a package edge (122);
- said substrate strip (101) having a opposite edge (118) on an opposite side opposite an side rail edge (120) of said single side rail (108); and
- said package edge (122) and said opposite edge (118) being spaced apart with respect to each other.

6. The substrate strip assembly (100, 200, 300) of one of claims 4 or 5, further comprising:
- a ball grid array (126) in at least one of said package regions (104);
- balls of said ball grid array (126) defining an outer edge of said ball grid array on said opposite side (112); and
- said outer edge of said ball grid array (126) and said opposite edge (118) being flush with respect to each other.

7. The substrate strip assembly (100, 200, 300) of one of claims 4 or 5, further comprising:
- a ball grid array (126) in at least one of said package regions (104);
- balls of said ball grid array (126) defining an outer edge of said ball grid array on said opposite side; and
- said outer edge of said ball grid array (126) and said opposite edge (128) being spaced apart with respect to each other.

8. A substrate panel (440) comprising at least two substrate strip regions (401, 401a, 401b) which are separable into individual substrate strips (101), each of said substrate strips (101) having
- a plurality of package regions (104) wherein each package region (104) includes an
integrated circuit; and
a single side rail (108) extending on a single side of said substrate strip (101) in a longitudinal direction, wherein said side rail (108) comprises at least one feature for processing said substrate strip (101).

9. Cassette (548) for receiving a substrate strip assembly (100, 200, 300) having a substrate strip (101), the cassette comprising:
- a first slot (550) for receiving a side rail edge (120) of said substrate strip (101);
- a second slot (552) comprising a first recess (554) for receiving an opposite edge (118) of said substrate strip (101), said opposite edge (118) being opposite said side rail edge (120);
- said second slot (552) comprising a second recess (556) for receiving a package housing (116) or balls of a ball grid array (126) of said substrate strip (101).

10. Method of fabricating packages comprising an integrated circuit, the method comprising:
- providing a substrate strip (101) comprising a plurality of package regions (104) which are separable into said packages, wherein said substrate strip (101) comprises a single side rail (108) extending on a single side of said substrate strip (101) in said longitudinal direction, said side rail (108) comprising at least one feature for processing said substrate strip (101);
- processing said substrate strip (101) using said at least one feature;
- removing said side rail (108) from said substrate strip (101).

11. Method according to claim 10, wherein providing said substrate strip (101) comprises:
- providing a substrate panel (440) comprising at least two substrate strip regions (401, 401a,401b);
- separating said at least two substrate strip regions, thereby providing said substrate strip (101).
